# EUROPEAN PATENT APPLICATION

(11) **EP 1 898 431 A1**
(43) Date of publication of application: **12.03.2008**
(21) Application number: 06747200.1
(22) Date of filing: 31.05.2006
(51) Int. Cl.: H01B 13/00, C22F 1/00, H01B 12/10

(54) **Nb3Sn SUPERCONDUCTING WIRE, PROCESS FOR PRODUCING THE SAME, AND SINGLE-CORE COMPOSITE WIRE USED IN PRODUCTION OF Nb3Sn SUPERCONDUCTING WIRE**

(30) Priority: 31.05.2005 JP 2005158330
(71) Applicant: The University of Tokushima, Tokushima-shi, Tokushima 770-0855 (JP)
(72) Inventor: INOUE, Kiyoshi, THE UNIVERSITY OF TOKUSHIMA, 2-chome Tokushima-shi Tokushima 7700814 (JP)
(74) Representative: Brown, Kenneth Richard
(86) International application number: PCT/JP2006/311364
(87) International publication number: WO 2006/129861

(57) **Abstract**

An Nb₃Sn wire rod having a high J_{c} value is manufactured using an Ag-Sn alloy. A composite rod including a plurality of Nb core materials incorporated in an Ag-Sn alloy matrix material having an Sn concentration of 9.35 to 22.85 at% is prepared. Next, the composite rod is extruded and/or wire drawn while carrying out process annealing of 350 to 490°C, followed by heat treatment at 500 to 900°C to produce an Nb₃Sn filament. Thus, an Nb₃Sn extrafine multi-core superconducting wire is manufactured.

## Description

### TECHNICAL FIELD

The present invention relates to an Nb₃Sn superconducting wire employing Ag-Sn alloy, a manufacturing method of the same, and a single-core composite wire used in the manufacture of the Nb₃Sn superconducting wire. The present invention also relates to an Nb₃Sn having a high Jc value (critical current density), and a manufacturing method therefor.

### BACKGROUND OF THE INVENTION

Conventionally, as practically-used manufacturing methods for an Nb₃Sn wire rod, a bronze process, an internal tin diffusion process, an MJR process (improved Jelly roll process), and a powder method are known, and are actually used as manufacturing methods for an Nb₃Sn wire rod for development of high magnetic field (see Non-patent Document 1). In each manufacturing method, because Nb₃Sn is produced at low temperature and in a short period of time, Cu contributes to a diffusion reaction.
[Non-patent Document 1] "SUPERCONDUCTING TECHNIQUE AND APPLICATION THEREOF" (edited by ISTEC journal editing committee), publishers: Nobuo SUZUKI, publication division, Tsuneo FUKAYAMA, published by Maruzen Co., Ltd., issued on October 31, 1996 (ISBN 4-621-04263-7 C3054)

The bronze process involves heating an extra fine multi-core wire rod in which Nb filaments are compounded in a bronze (Cu-Sn alloy) matrix, and generating an Nb₃Sn layer due to a diffusion reaction between Nb and bronze. In the bronze process, because Cu containing a great deal of low-concentration Sn finally remains in a wire rod as a matrix, it is known that the bronze process has a disadvantage that a non-Cu overall Jc value (critical current density per the total cross section of the wire rod except Cu) becomes small.

Moreover, when an Nb₃Sn wire rod is used in an NMR spectrometer high magnetic field magnet, which is its most common application, it is preferable for the value of current allowed to pass in a permanent current mode operation, in which the resistance is substantially near zero, to be large. As an index for evaluating the permanent current mode operation in terms of engineering, an n value is known in which, logV/logI in the vicinity of the critical current value is equal to n, in which a current value passing through a superconducting wire is defined as I and a generated voltage is defined as V. It is also known that wire rods with higher n values can be used in a permanent current mode nearly up to the actually measured overall Jc (critical current density per the total cross section of a wire rod). Although the physical meaning of this n value is not thoroughly elucidated, it is known that the n value strongly depends on uniformities of shapes and properties of superconducting filaments of extra fine multi-core wires in a wire rod, and when the uniformity is higher, the n value is larger. In terms of the n value, the bronze process can provide an Nb₃Sn wire rod with a large n value. This is because, due to the similarity in the hardness between bronze and Nb, the workability of a composite in a stage of producing a wire rod is remarkably excellent and it is possible to produce a wire rod which is free from abnormal deformation and has a uniform and regulated cross section.

In contrast, in the internal tin diffusion process, the MJR method (improved Jelly roll process), and the powder method for producing Nb₃Sn wire rods other than the bronze process, the Sn concentration (Sn is incorporated in a wire rod in the form of a pure Sn or Sn-rich compound powder) in a wire rod is higher than that of a wire rod in the bronze process. Therefore, Nb₃Sn having excellent properties closer to a stoichiometric composition is generated to thereby enables to reduce the volume fraction of an excess Cu-Sn alloy remaining after the completion of a diffusion reaction, and high magnetic field properties can be sharply improved. However, according to the manufacturing method, since the wire drawing workability is not so good, shapes of superconducting filaments deform and the n value becomes small. Thus, such a manufacturing method is not suitable for the use in a permanent current mode. This is because a wire rod is excessively soft due to the use of pure Sn, so composite processing is hindered, and also compound powders are likely to suffer from abnormal deformation.

Therefore, recently, there has been an increase of research into a process of producing a wire rod using bronze containing Sn close to the solid solution boundary or Sn slightly exceeding the solid solution boundary in the bronze process wire rod for NMR. However, the solid solution limit of Sn in bronze is 9.1 at%, and when Sn dissolves exceeding the limitation, an intermetallic compound precipitates. Therefore, workability is worsened and improvements in the properties in this aspect have nearly approached the limit.

### DISCLOSURE OF THE INVENTION

The inventors of the present invention carried out extensive research in order to overcome the above-mentioned problems and reached the present invention. More specifically, the present invention aims to obtain a superconducting wire with a different approach from the conventional techniques described above.

An embodiment of the present invention provides a method of manufacturing an Nb₃Sn superconducting wire including: filamentizing a composite in which a core material containing an Nb material is incorporated in a matrix material containing an Ag-Sn alloy; and heating the composite to form an Nb₃Sn filament, in which
the composite is filamentized at a temperature at which the Ag-Sn alloy is in a state where an fcc phase and a ζ phase are mixed while adjusting an Sn concentration of the Ag-Sn alloy in such a manner that the Ag-Sn alloy can enter the state where the fcc phase and the ζ phase are mixed, or
the composite is filamentized at a temperature at which the Ag-Sn alloy is in a state in the ζ phase while adjusting an Sn concentration of the Ag-Sn alloy in such a manner that the Ag-Sn alloy can enter the state in the ζ phase.

Conventionally, with respect to Ag-Sn alloy, alloy compositions has excellent workability when Sn concentration is up to about 9 at% in an fcc phase, and when the Sn concentration is higher than 9 at%, workability is presumed to be reduced, resulting in poor practicability. The inventors of the present invention found that when Ag-Sn alloy is in a state where a ζ phase and an fcc phase are mixed or Ag-Sn alloy is in a state in a ζ phase, favorable malleability can be achieved at a temperature at the time of filamentization or at room temperature.

Based on those findings, a superconducting wire is manufactured by:
1) filamentizing the Ag-Sn alloy at a temperature at which the Ag-Sn alloy in the fcc phase and the Ag-Sn alloy in the ζ phase are mixed while adjusting the Sn concentration of the Ag-Sn alloy in such a manner that the Ag-Sn alloy can enter a state where the Ag-Sn alloy in the fcc phase and the Ag-Sn alloy in the ζ phase are mixed; or
2) filamentizing the Ag-Sn alloy at a temperature at which the Ag-Sn alloy is in the ζ phase while adjusting the Sn concentration of the Ag-Sn alloy in such a manner that the Ag-Sn alloy enters the ζ phase.

Moreover, because the Ag-Sn alloy having such an Sn concentration has excellent workability, filamentization thereof is not hindered.

Further, another embodiment of the present invention provides a method of manufacturing an Nb₃Sn superconducting wire including: filamentizing a single-core composite in which a core material containing an Nb material is incorporated in a matrix material containing an Ag-Sn alloy; forming a multi-core composite containing a plurality of the filamentized single-core composites; filamentizing the multi-core composite; and heating the multi-core composite to form an Nb₃Sn filament, in which
the composite is filamentized at a temperature at which the Ag-Sn alloy in an fcc phase and the Ag-Sn alloy in a ζ phase are mixed while adjusting an Sn concentration of the Ag-Sn alloy in such a manner that the Ag-Sn alloy can enter the state where the Ag-Sn alloy in the fcc phase and the Ag-Sn alloy in the ζ phase are mixed, or
the composite is filamentized at a temperature at which the Ag-Sn alloy is in a state in the ζ phase while adjusting the Sn concentration of the Ag-Sn alloy in such a manner that the Ag-Sn alloy can enter the state in the ζ phase.

Thus, by producing a single-core composite, and hen filamentizing a multi-core composite containing a plurality of the single-core composites, a superconducting wire having more excellent properties can be obtained.

In particular, the critical current value I_{c} in a superconducting wire manufactured using a multi-core composite is as high as ten times to several hundred times the Ic value in a single-core wire rod. By increasing the number of cores, an I_{c} value higher than predicted by the conventional techniques can be acquired.

Production of a superconducting wire requires at least the following three steps:
1. obtaining a composite of Nb and Ag-Sn alloy;
2. filamentizing the composite; and
3. subjecting the filamentized composite to diffusion heat treatment, to generate Nb₃Sn.

A composite of Nb and Ag-Sn alloy can be manufactured through, for example, the following steps 1) to 4):
Step 1) bundling the filamentized single-core wires;
Step 2) pouring Ag-Sn into a container containing a plurality of Nb rods (e.g. , assuming that the volume ratio of Nb core material to Ag-Sn alloy is 1 : 1 , when Ag-Sn of 1,000 °C is poured in a container containing an Nb core material at room-temperature, the temperature is lowered to 500°C in the order of several seconds. Since a diffusion reaction between Nb and Ag-Sn alloy does not occur in several seconds, Nb₃Sn is not generated in this case);
Step 3) forming many holes in an Ag-Sn matrix with a gun drill, and inserting the Nb rods; and
Step 4) forming many holes in an Nb matrix with a gun drill, and inserting the Ag-Sn rods.

Filamentization of the multi-core composite thus obtained can be performed through, for example, the following steps 1) to 3).

Step 1) Process annealing (300°C or higher to lower than 500°C), filamentization (cold working: up to 100°C), and annealing are repeated. The reason why the annealing is performed resides in that there is a possibility that the composite may break when cold-filamentized. The cold working can be performed when the Sn concentration of Ag-Sn is 18 at% or lower where the Ag-Sn alloy is in a state in the ζ phase or is 19 at% or lower where the precipitation amount is small even if the Ag-Sn alloy in an ε phase precipitates.

Step 2) Warm working is performed (100°C or higher to lower than 300°C, e.g., performing hot working at about 250°C while applying Si oil).

Step 3) Hot working is performed (300°C or higher to lower than 500°C). This treatment is suitable when the Sn concentration of Ag-Sn is about 20 to 22%.

Temperatures at the time of filamentization need to be adjusted in such a manner that Nb₃Sn is not generated as described later in detail. Thus, although the range of existence in the ζ phase extends to 724°C, the upper limit temperature of filamentization is lower than 724°C, e.g., 500°C or lower, or 600°C or lower.

Further, a filamentized composite can be heated as follows.

Step 1) When Nb is a matrix material, heating is performed at 500 to 900°C. A heating time changes according to the heating temperature in this case, and, for example, when a heating temperature is 650 ° C, a heating time is several hundred hours; when a heating temperature is 700°C, a heating time is 40 hours; and when a heating temperature is 850°C, a heating time is about several hours.

Step 2) When Ag-Sn alloy is a matrix material, heating is performed at 500 to 724°C. A composite forms a filament with several tens of micrometers or less through filamentization. Thus, in order to hold an Nb rod material at a desired position, the Ag-Sn alloy needs to be solid. Based on the fact that the temperature of Ag-Sn alloy exceeds 724°C, the Ag-Sn alloy begins to liquefy, a heating temperature needs to be 724°C or lower.

When the Ag-Sn alloy in the fcc phase and the Ag-Sn alloy in the ζ phase are mixed or the Ag-Sn alloy is in the ζ phase, the workability of Ag-Sn alloy is excellent, and a processing performed at a temperature equals to or lower than the annealing temperature, i.e., cold working, can be carried out.

The annealing of Ag-Sn alloy is usually performed at a temperature ranging from about 350 to 490°C. At a temperature ranging from room temperature to about 180°C, the Ag-Sn alloy in the fcc phase and the Ag-Sn alloy in the ζ phase are mixed when the Sn concentration of the Ag-Sn alloy is 9.35 at% or higher, and cold working can be performed.

At a temperature ranging from room temperature to about 180°C, the upper limit of the Sn concentration at which the Ag-Sn alloy in the fcc phase and the Ag-Sn alloy in the ζ phase are mixed is 11.8 at%.

Therefore, it is preferable that the lower limit of the Sn concentration at which the Ag-Sn alloy in the fcc phase and the Ag-Sn alloy in the ζ phase are mixed be 9.35 at% and the upper limit thereof be 11.8 at%.

With respect to the Ag-Sn alloy, as a temperature increases from 200°C to 724°C, the lower limit of the Sn concentration at which the Ag-Sn alloy in the fcc phase and the Ag-Sn alloy in the ζ phase are mixed increases from 9.35 at% to 11.5 at%. The annealing of the Ag-Sn alloy is usually performed at a temperature ranging form about 350 to 490°C. In view of this, when the Sn concentration in the Ag-Sn alloy is, for example, higher than 10.0 at%, the Ag-Sn alloy in the fcc phase and the Ag-Sn alloy in the ζ phase are mixed even at this annealing temperature. Therefore, it is preferable that the lower limit of the Sn concentration at which the Ag-Sn alloy can enter a state where the Ag-Sn alloy in the fcc phase and the Ag-Sn alloy in the ζ phase are mixed be higher than 10.0 at%.

The minimum Sn concentration at which the Ag-Sn alloy is in the ζ phase is 11.8 at%, and the maximum is 22.85 at%. Therefore, it is preferable that the Sn concentration at which the Ag-Sn alloy can enter a state in the ζ phase be within the range of 11.8 at% to 22.85 at%.

Considering the fact that the lower limit of the Sn concentration at which the Ag-Sn alloy enters the ζ phase at around room temperature is 11.8 at% and the upper limit thereof is 18 at%, it is more preferable for the Sn concentration of the Ag-Sn alloy to be within the range of 11.8 at% to 18 at%. This concentration range is advantageous in that, even if heating is performed for filamentization, and then the temperature is cooled to room temperature, the Ag-Sn alloy always maintains the ζ phase.

Further, in the Ag-Sn alloy whose Sn concentration is within the range of 12 to 13 at%, the hardness of this Ag-Sn alloy becomes approximately equal to the hardness of Nb. Thus, remarkably excellent compound workability with Nb can be acquired. In the fcc phase, the hardness of the Ag-Sn alloy is not in agreement with the hardness of Nb, and the hardness of Nb is higher. In view of this, when the Sn concentration in the Ag-Sn alloy is adjusted to 12 to 13 at%, the composite workability can be made higher than that obtained by a conventional manufacturing method using the Ag-Sn alloy.

When the Sn concentration is within the range of 18 at% to 22.85 at%, the Ag-Sn alloy in an ε phase precipitates as the Ag-Sn alloy deviates from the ζ phase region when the Ag-Sn alloy is cooled after the filamentization in the ζ phase. For example, when the Ag-Sn alloy whose Sn concentration is 21% is filamentized at a temperature at which the Ag-Sn alloy enters the ζ phase, and then cooled to room temperature, the Ag-Sn alloy in the ε phase precipitates in the form of powder in the ζ phase whose Sn concentration is about 18%.

Thus, even in a state where the Ag-Sn alloy deviates from the ζ phase and the Ag-Sn alloy in the å phase precipitates after cooling, the superconducting properties such as Tc, Ic, etc., in the superconducting wire obtained by heat treatment for generating Nb₃Sn are not adversely affected. However, because the Ag-Sn alloy becomes weak, cautions are required for the handling thereof.

It should be noted that when heat-treatment for the generation of Nb₃Sn is performed in a state where the Ag-Sn alloy in the å phase precipitates, Nb reacts with Sn. As a result, the Sn concentration of the Ag-Sn alloy decreases, and the å phase disappears in most cases. Therefore, even when a superconducting wire is manufactured within the Sn concentration range of 18 at% to 22.85 at%, the influence of "brittleness" is hardly observed in the manufactured superconducting wire.

Further, if heat treatment for the generation of Nb₃Sn is performed, the Sn concentration of the Ag-Sn alloy may decrease until the ζ phase disappears in some cases. Because the fcc phase itself is not weak unlike the å phase, there is no possibility that the Ag-Sn alloy may become brittle.

Therefore, a superconducting wire manufactured, according to the present invention, by filamentizing at a concentration and a temperature at which the ζ phase is present in at least one portion may contain or may not contain the Ag-Sn alloy in the ζ phase. It should be noted that the superconducting wire Ag-Sn alloy containing the Ag-Sn alloy in the ζ phase can be said to be produced by filamentization in the ζ phase according to the present invention.

The heating temperature at the time of filamentization may be a temperature at which the Ag-Sn alloy in the fcc phase and the Ag-Sn alloy in the ζ phase are mixed or the Ag-Sn alloy enters the ζ phase and Nb₃Sn does not precipitate. Nb₃Sn starts to precipitate at 500 to 550°C depending on various conditions, and, in most cases, Nb₃Sn precipitates at 650°C. Thus, the upper limit of the heating temperature at the time of filamentizazion is preferably 650°C or lower, more preferably 600°C or lower, still more preferably 550°C or lower, and yet still more preferably 500°C or lower.

It should be noted that annealing is not always required at the time of filamentization. When the filamentization can be performed without breaking the composite, annealing is not necessary. According to one embodiment, filamentizing is carried out by repeating a cold working filamentization process at 100°C or lower and annealing for avoiding the composite from breaking (annealing at a temperature at which Nb₃Sn is not generated or lower) . According to another embodiment, filamentizing is performed at a temperature at which the composite is hard to break, e.g., 200°C, without annealing.

When the Sn concentration of the Ag-Sn alloy exceeds 18 at%, the Ag-Sn alloy does not enter the ζ phase at room temperature, cold working becomes difficult. Even if the Sn concentration exceeds 18 at%, in the case where the Ag-Sn alloy is heated to enter the ζ phase, and then cooled, and also the cooling rate is high, the ζ phase, although unstable, can be maintained for a certain period of time at low temperatures at which the Ag-Sn alloy does not enter the ζ phase in a phase diagram. Thus, even if the Sn concentration is within the range of 18 at% to 22.85 at%, cold working can be carried out by adjusting the cooling rate. The phase diagram of alloy illustrates a state of the alloy after an infinite time passed. For example, even if the Sn concentration of the Ag-Sn alloy is 22 at%, the Ag-Sn alloy is heated to enter the ζ phase and cooled rapidly, whereby the ζ phase can be transiently maintained at a temperature of 100°C or lower at which cold working is performed and cold working can be carried out under such conditions.

Thus, in the case where cold working is performed while adjusting the cooling rate and the cold working time, the Sn concentration of the Ag-Sn alloy is 18 at% to 23.85 at%, and preferably 18 at% to 22 at%.

The filamentization can be performed by any processes without limitation, and preferably by extruding, wire drawing (drawing), etc., and more preferably by extruding and by drawing after the extruding process.

In the above-mentioned manufacturing methods for Nb₃Sn extra fine multi-core superconducting wires, the Sn concentration of an Nb₃Sn superconducting wire generated by the diffusion reaction between Nb and Ag-Sn alloy can be increased by using Ag-Sn alloy in place of bronze, which has been conventionally used as a matrix material.

When Cu-Sn alloy is used in the conventional bronze process, the upper limit of the Sn concentration of the Cu-Sn alloy is 9.1 at% in a Cu-Sn phase diagram, which is the solid solution limit of Sn in the fcc phase in which an intermetallic compound with poor workability does not precipitate. However, in the present invention, due to the use of the Ag-Sn alloy, the solid solution limit of Sn in the fcc phase is 11.5 at% in the Ag-Sn phase diagram. Even when the Sn concentration becomes higher, an alloy phase referred to as a ζ phase, in which cold working can be performed, appears. Thus, the solid solution limit of Sn in the ζ phase, i.e. , 22.85 at%, can be determined as the upper limit of the Sn concentration of a matrix material.

More specifically, according to the present invention, alloy whose concentration is higher than the maximum Sn concentration in the bronze process, i.e., specifically, alloy whose concentration is a maximum of 2.6 times the Sn concentration in the bronze process can be contributed to the diffusion reaction. Therefore, a wire rod can be designed in such a manner that the amount of the Ag-Sn alloy remaining after the diffusion reaction (the Ag-Sn alloy has a phase which is required for the diffusion reaction, but is not necessary in a wire rod in the end) can be reduced to about 1/3 with respect to the amount of residual Cu-Sn alloy in the bronze process. Moreover, the superconducting properties of the obtained Nb₃Sn can be sharply improved.

Especially, as superconducting properties, the overall J_{c} at around 20 T can be improved, and, specifically, can be improved by about 3 to 4 times in a particularly suitable embodiment. Further, because an n value of the present invention can be expected to have the same degree as that in a wire rod according to the bronze process, the present invention can be suitably used for a high magnetic field magnet for NMR spectrometer. Moreover, in addition to the NMR spectrometer, the present invention is generally suitable for the development of high magnetic field compared with the conventional Nb₃Sn wire rod. Therefore, the invention is suitable for high magnetic field energy storage, high magnetic field MRI, nuclear fusion reactor, high magnetic field dipole magnet, etc. Because the price of Nb is almost the same as that of Ag, the overall J_{c} is improved by about 3 times. Thus, the amount of the wire rod to be used is reduced to 1/3 in a preferable embodiment of the present invention. Therefore, the manufacturing cost of an NMR spectrometer can be reduced.

Moreover, in the manufacturing method for the Nb₃Sn multi-core superconducting wire according to the present invention, it is preferable to shape a wire rod into the form of an extra fine multi-core wire in order to suppress flux jump resulting from rapid rearrangement of lines of magnetic flux. Although the composite is filamentized by extruding or wire drawing (drawing) by stretching, it is preferable to stretch the composite by extruding. The diameter of a final superconducting filament is preferably several tens im or smaller. In order to generate an Nb₃Sn layer by the diffusion reaction between Ag-Sn and Nb, it is preferable to perform heat treatment at temperatures of 500°C or higher. When a diffusion temperature becomes 900 °C or higher, the crystal growth rate becomes excessively high. Therefore, it is difficult to generate Nb₃Sn fine particles having high J_{c}. In view of this, the diffusion temperature is preferably up to 900°C, and more preferably up to 880°C.

When manufacturing an Nb₃Sn superconducting wire, it is preferable to produce an Nb₃Sn multi-core superconducting composite by inserting single-core composites in an Ag-Sn alloy pipe whose Sn concentration is higher than 9.35 at% and equal to or lower than 22.85 at%, and filamentizing the multi-core composite.

In each of the above-mentioned embodiments, the Ag-Sn alloy is used as the matrix material and the Nb material is used as the core material. However, in another embodiment, the Nb material can be used as the matrix material and the Ag-Sn alloy can be used as the core material. Also in this case, Nb₃Sn is formed at the boundary between the Nb material and the Ag-Sn alloy, and an Nb₃Sn superconducting wire can be obtained. Also in this embodiment, conditions, such as the Sn concentrations and the heating temperatures at the time of filamentization, are the same as that in the above-mentioned embodiments in which the Ag-Sn alloy is used as the matrix material and the Nb material is used as the core material.

Preferably, 4 at% or lower Ti and/or 8 at% or lower Ta are incorporated in the Ag-Sn alloy. Thus, by separately adding a slight amount of Ti or Ta or simultaneously adding Ta and Ti to the Ag-Sn alloy matrix material, the H_{c2} (upper critical magnetic field) of Nb₃Sn and the J_{c} in a high magnetic field can be improved. However, the addition of 4 at% or higher Ti and/or 8 at% or higher Ta has a possibility of degrading the superconducting properties, and thus is not desirable.

Preferably, 4 at% or lower Ti and/or 8 at% or lower Ta are incorporated in the Nb material. Thus, by separately adding a slight amount of Ti or Ta or simultaneously adding Ta and Ti to the Nb material, the H_{C2} (upper critical magnetic field) of Nb₃Sn and the J_{c} in a high magnetic field can be improved. However, the addition of 4 at% or higher Ti and/or 8 at% or higher Ta has a possibility of degrading the superconducting properties, and thus is not desirable.

Preferably, when the Ag-Sn alloy is used as the matrix material, a stabilizer containing Cu or Ag is compounded into the matrix material through a diffusion barrier material containing Ta or Nb foil. In this case, by compounding the stabilizer into the matrix material of Ag-Sn alloy, the Nb₃Sn extra fine multi-core superconducting wire to be obtained can be imparted with effects, such as an electric bypass at the time when superconductivity is temporarily lost, magnetic damping, thermal diffusion, etc., thereby improving the stability of a superconductive phenomenon. It is preferable that Ag and/or Cu of the stabilizer to be compounded into the matrix material have high purity so as to improve the stability of a superconductive phenomenon. Therefore, the stabilizer needs to be compounded with the matrix material through a barrier material so that Sn of the Ag-Sn alloy of the matrix material may not be diffused in the stabilizer. This is realizable by sandwiching the barrier material between the matrix material and the stabilizer. Moreover, Ta and Nb do not react with Cu and Ag, and are materials with excellent cold working properties, thus, Ta and Nb are suitable as the diffusion barrier material. Also in the configuration of a final wire rod, the diffusion barrier material needs to be sandwiched between the stabilizer and a layer containing Sn (Nb₃Sn layer and Ag-Sn alloy layer).

Preferably, when the Nb material is used as the matrix material, a stabilizer containing Cu or Ag is compounded. In this case, by compounding the stabilizer into the matrix material, the Nb₃Sn extra fine multi-core superconducting wire to be produced can be imparted with effects, such as an electric bypass, magnetic damping, thermal diffusion, etc., at the time of a superconducting phenomenon, thereby improving the stability of a superconductive phenomenon. It should be noted that because Nb is used as a matrix material, the Nb matrix itself serves as the diffusion barrier, which eliminates the necessity of sandwiching a new barrier material. Also in the configuration of a final wire rod, Nb needs to be sandwiched between the stabilizer and a layer containing Sn (Nb₃Sn layer and Ag-Sn alloy layer) in such a manner as to serve as the diffusion barrier.

Further, the present invention provides an Nb₃Sn superconducting wire, including: a core material containing an Nb material incorporated in a matrix material containing an Ag-Sn alloy in a ζ phase; and Nb₃Sn formed at a boundary between the core material and the Ag-Sn alloy. In addition, there is also provided an Nb₃Sn superconducting wire, including: a core material containing an Ag-Sn alloy in a ζ phase incorporated in a matrix material containing an Nb material; and Nb₃Sn formed at a boundary between the core material and the Ag-Sn alloy.

It is preferable for each of the Nb₃Sn superconducting wires to have a configuration of an Nb₃Sn multi-core superconducting wire containing a plurality of core materials. The Sn concentration of the Ag-Sn alloy in the ζ phase is preferably within the range of 9.35 at% to 22.85 at%.

Thus, by the use of the Ag-Sn alloy in the ζ phase, in the same manner as in the manufacturing method for the Nb₃Sn superconducting wire of the present invention described above, various effects can be obtained: a wire rod can be designed in such a manner that the amount of the Ag-Sn alloy remaining after the diffusion reaction can be reduced to about 1/3 with respect to the amount of remaining Cu-Sn alloy in the bronze process; the present invention can be suitably used for high magnetic field magnet for NMR spectrometer; and the like.

Further, another embodiment of the present invention provides a single-core wire rod, which is a single-core wire rod for manufacturing an Nb₃Sn multi-core superconducting wire, including a core material containing an Nb material incorporated in a matrix material containing an Ag-Sn alloy in a ζ phase. In addition, there is also provided a single-core wire rod, which is a single-core wire rod for manufacturing an Nb₃Sn multi-core superconducting wire, including a core material containing an Ag-Sn alloy in a ζ phase incorporated in a matrix material containing an Nb material.

Those single-core wire rods are used for manufacturing the above-mentioned Nb₃Sn multi-core superconducting wire. Preferably, by using a plurality of the single-core wire rods, an Nb₃Sn multi-core superconducting wire can be obtained. More specifically, the Nb₃Sn multi-core superconducting wire can be obtained by inserting the single-core wire rods into a pipe composed of Ag-Sn alloy or the Nb material, filamentizing the resultant, and then heating the resultant to generate an Nb₃Sn filament. The single-core wire rod using the Ag-Sn alloy in the ζ phase in the above-mentioned embodiments are not conventionally known. The use of a plurality of the single-core wire rods allows production of an Nb₃Sn multi-core superconducting wire having the above-mentioned outstanding properties.

In order to improve the high magnetic field properties of Nb₃Sn, the internal Sn diffusion method, the MJR method, the powder method, etc., the methods which can readily increase the Sn concentration, have been studied. However, a wire rod with a high n value cannot be obtained, and in the actual NMR spectrometer, a wire rod using bronze whose Sn concentration is increased up to its limit has been mainly used. According to the manufacturing method for the Nb₃Sn extra fine multi-core superconducting wire of the present invention, the overall J_{c} under a high magnetic field is improved. Particularly in a suitable embodiment, the overall J_{c} at around 20 T can be improved by about 3 to 4 times. Further, because the present invention can provide an Nb₃Sn extra fine multi-core superconducting wire whose n value can be expected to have the same degree as that in a superconducting wire rod according to the bronze process, a high-performance MMR spectrometer can be manufactured.

Compared with the bronze process, because Ag is used in place of Cu, a raw material cost becomes high, but the price of Nb is almost the same as that of Ag. Therefore, an effect that the amount of a wire rod to be used can be reduced (reduced by about 1/3 in a suitable embodiment) can be acquired by improving the overall J_{c} using Ag (improving by about 3 times in a suitable embodiment). Thus, the manufacturing cost of an NMR spectrometer can be reduced. Especially in a suitable embodiment in which the overall J_{c} is improved by about 3 times, the manufacturing cost of an NMR spectrometer can be reduced to a large degree.

### BRIEF DESCRIPTION OF THE DRAWINGS

Fig. 1 is a phase diagram of Ag-Sn alloy.
Fig. 2 is a view illustrating a cross sectional structure of a precursor wire rod according to Test Example 2.
Fig. 3 is a view illustrating a cross sectional structure of a precursor wire rod according to Test Example 3.
Fig. 4 is a view illustrating a cross sectional structure of a precursor wire rod according to Test Example 4.
Fig. 5A is a cross sectional view illustrating a superconducting wire.
Fig. 5B is a cross sectional view illustrating a superconducting wire.
Fig. 6 is an explanatory diagram illustrating a cross sectional structure of a precursor wire rod according to Test Example 5.
Fig. 7 is an explanatory diagram illustrating a cross sectional structure of a precursor wire rod according to Test Example 6.
Fig. 8 is an explanatory diagram illustrating a cross sectional structure of a precursor wire rod according to Test Example 7.
Fig. 9 is an explanatory diagram illustrating a cross sectional structure of a precursor wire rod according to Test Example 8.
Fig. 10 is an explanatory diagram illustrating a cross sectional structure of a precursor wire rod according to Test Example 9.
Fig. 11 is an explanatory diagram illustrating a cross sectional structure of a precursor wire rod according to Test Example 10.
Fig. 12 is an explanatory diagram illustrating a cross sectional structure of a precursor wire rod accoding to Test Example 11.
Fig. 13 is an explanatory diagram illustrating a cross sectional structure of a precursor wire rod accoding to Test Example 12.
Fig. 14 is an explanatory diagram illustrating measurement results of values of H_{c}2, Ic (A) , and Tc (K) in each superconducting wire.

### BEST MODE FOR CARRYING OUT THE INVENTION

Hereinafter, the present invention will be described with reference to the drawings according to the embodiments, but is not limited thereto.

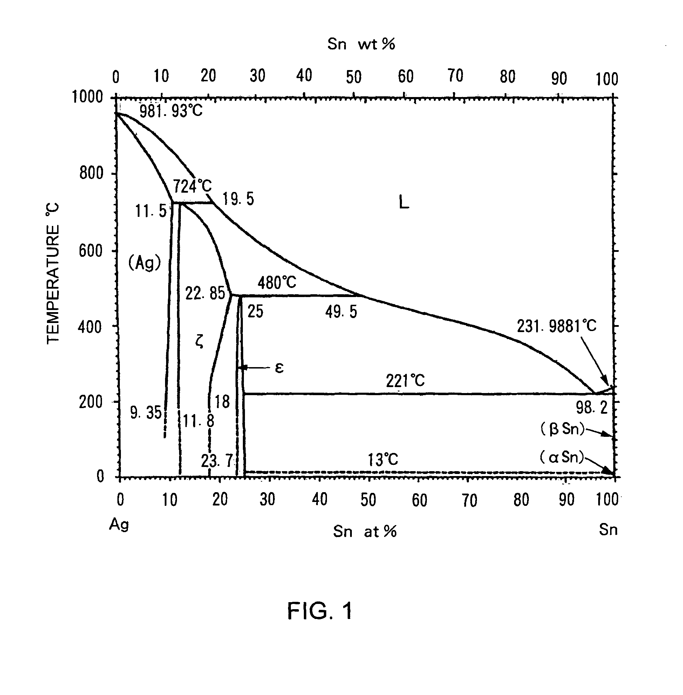

Fig. 1 shows a phase diagram illustrating Sn concentrations and temperatures at which Ag-Sn alloy enters a ζ phase. As illustrated in Fig. 1, in the phase diagram in which the Sn concentrations of the Ag-Sn alloy are plotted along the axis of abscissa and the temperatures are plotted along the axis of ordinate, the Ag-Sn alloy can enter the ζ phase in a region where the Sn concentration ranging from 11.8 at% to 22.85 at% and the temperatures ranging from 0 to 724°C.

In Fig. 1, in the region where the Sn concentration is 9.35 at% or lower and the temperature is not excessively high, the Ag-Sn alloy is in an fcc phase. It is conventionally known that sufficient workability can be acquired in the fcc phase.

In contrast, when the Sn concentration of the Ag-Sn alloy becomes high and the Ag-Sn alloy deviates from the fcc phase, it is considered that workability is worsened and filamentization at the time of producing a superconducting wire becomes difficult. Thus, a superconducting wire having an Sn concentration at which the Ag-Sn alloy deviates from the fcc phase was not manufactured.

However, as illustrated in the following test examples, the workability of the Ag-Sn alloy was excellent in the ζ phase region illustrated in Fig. 1. Based on this fact, it was found that an Nb₃Sn superconducting wire can be obtained by filamentizing in the ζ phase. An Nb₃Sn superconducting wire can be obtained by using Ag-Sn alloy whose Sn concentration is as high as 11.8 at% to 22.85 at%, and the Nb₃Sn superconducting wire thus obtained exhibits excellent properties.

### (Test Example 1)

A single-core composite rod was produced as a single-core composite in which an Nb rod was inserted in a pipe of Ag-Sn alloy whose Sn concentration was 12 at%, i.e., an Ag-12 at% Sn alloy pipe, (the outside diameter of 20 mm, the inside diameter of 14 mm, and the length of 90 mm). The single-core composite rod was heated and filamentized. In this test example, wire drawing work was preformed while applying process annealing of 400°C, thereby producing a single-core composite wire having a diameter of 0.87 mm. The single-core composite wire was heated at 650 to 850°C under vacuum, thereby obtaining a single-core superconducting wire. The heat-treatment was performed so that Nb₃Sn may be generated at the boundary between the Ag-Sn alloy and the Nb. Therefore, the heat treatment was performed for several hours to 100 hours according to the heating temperatures, and for example, the heat treatment was required to be performed for several hundred hours at 650°C; for 40 hours at 700°C; and for several hours at 850°C. In this test example, the heat-treatment was performed at 700°C for 50 hours, and thereafter, the superconducting properties were measured.

The superconducting properties vary depending on heat treatment conditions, and the T_{c} values were typically 15.2 to 17.3 K. The H_{c2} (4.2 K) value were 15 to 19 T. In contrast, the I_{c} value was not so large as compared with that of an Nb₃Sn wire rod obtained by the bronze process, and values of about several hundred mA to 1 A at 14 T and 4.2 K and values of several A to 10 A at 8t and 4.2 K were obtained.

When the cross section of the wire rod was observed using an optical microscope or SEM, it was found that the thickness of the Nb₃Sn layer generated at the boundary between the Nb and the Ag-12 at% Sn alloy was 0.5 im or lower. This means that an Nb₃Sn diffusion/formation promoting effect which is observed in Cu is quite small or is hardly observed as compared with Cu. Further, the J_{c} value based on a compound layer of Nb₃Sn can be estimated to be 1,000 A/mm² or higher at 4.2 K and 14 T. This value is equivalent to or higher than the J_{c} value of an Nb₃Sn wire rod obtained by the bronze process.

In view of the above, the single-core wire rod obtained in Test Example 1 showed superconducting properties, and can be used as an Nb₃Sn superconducting wire. Moreover, the superconducting properties thereof are similar to those of the superconducting wire obtained by the bronze process. As described above, the Nb₃Sn diffusion/formation promoting effect of Ag is small as compared with that of Cu. Therefore, when compared with the Nb₃Sn superconducting wire obtained by the bronze process, there is a possibility that the thickness of the Nb₃Sn decreases and the overall J_{c} is lowered, assuming that the Sn concentrations are the same. However, considering the fact that a practically-used superconducting wire has an extra fine multi-core wire configuration, influences of the thickness of the Nb₃Sn do not presumably appear. Moreover, because Sn can be used at higher concentrations in the present invention than in the bronze process, the superconducting properties of the superconducting wire to be obtained by the present invention can be further improved compared with the superconducting properties of the superconducting wire obtained by the bronze process.

Further, the single-core composite wire obtained in this test example can also be used as a single-core composite wire for producing an Nb₃Sn multi-core superconducting wire described in the following Test Example 2.

### (Test Example 2)

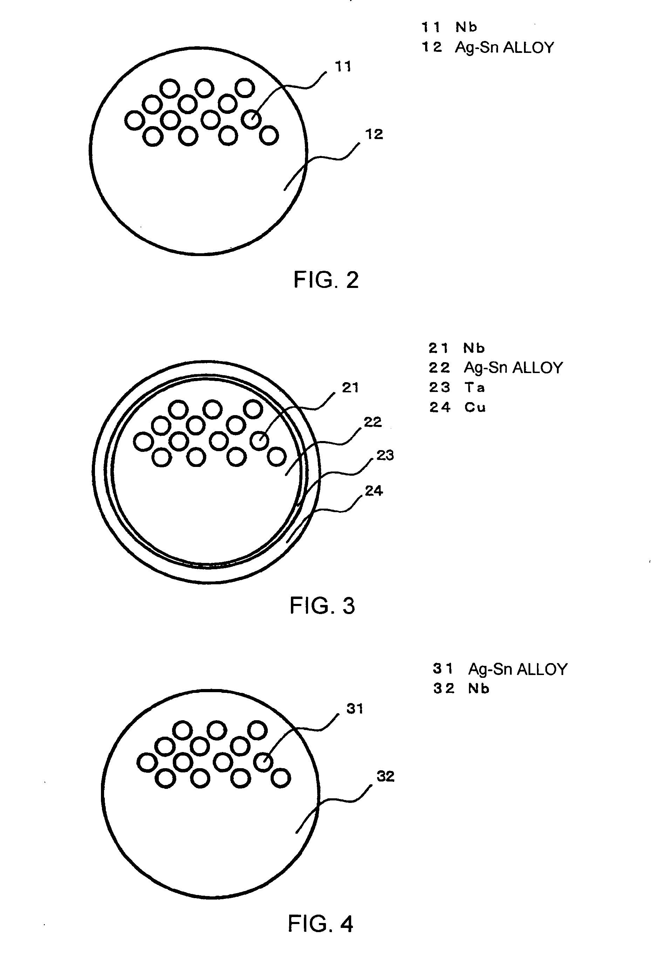

A single-core composite rod was produced as a single-core composite in which an Nb rod was inserted in an Ag-12 at% Sn alloy pipe, (the outside diameter of 20 mm, the inside diameter of 14 mm, and the length of 90 mm). The single-core composite rod was subjected to wire drawing work while applying process annealing of 400°C, thereby producing a single-core composite wire having a diameter of 0.87 mm. Subsequently, the obtained single-core composite wire was cut to 100 mm length, and 200 wires were bundled. The bundle of wires was inserted in an Ag-12 at% Sn alloy pipe (the outside diameter of 20 mm, the inside diameter of 14 mm, and the length of 90 mm), thereby producing a 200-core composite rod. Thereafter, the 200-core composite rod was subj ected to wire drawing while applying process annealing of 400°C, thereby producing a precursor wire rod, which was a 200-core composite wire having a diameter of 0.87 mm. Fig. 2 illustrates the cross sectional structure of the precursor wire rod. The precursor wire rod was heated at a temperature within the range of 650 to 850°C under vacuum for several hours to 100 hours, thereby producing an Nb₃Sn extra fine multi-core superconducting wire.

The superconducting properties vary depending on the heat treatment conditions, and the T_{c} (critical temperature) value was 16.5 to 17.8 K, which is T_{c} value of a typical Nb₃Sn wire rod, and it was found that an Nb₃Sn layer is generated due to the diffusion reaction between the Ag-Sn alloy and the Nb. The each H_{c2} (4.2 K) value was 17 to 23 T, and corresponds to the H_{c2} (4.2 K) value of a typical additive-free Nb₃Sn wire rod. In contrast, the each I_{c} value (4.2 K, 14 T) (critical current at 4.2 K and 14 T) reached 10 A to 100 A, which was much higher than the I_{c} value (4.2K, 14T) expectable from the results of a single-core wire, and was interesting value for practical use. Considering the fact that the cross sectional structure of the wire rod was not optimized, it is possible to obtain a wire rod having still higher I_{c} value by future studies.

In other words, the results show that a high non-Cu overall J_{c} exceeding value of a range from typical non-Cu overall J_{c} (4.2K, 14T) to 600 A/mm² of a practically used Nb₃Sn extra fine multi-core wire obtained by the bronze process can be acquired by optimizing the cross sectional structure in the Nb₃Sn wire rod produced by the manufacturing method proposed by the present invention.

Thus, it is shown that the I_{c} value is remarkably increased by increasing the number of cores (multi-core) compared with the I_{c} value of a single-core wire rod. The cause therefor is not sufficiently specified, but at a present stage, it is presumed that the cause resides in shortened diffusion distance.

### (Test Example 3)

A Ta pipe with an outside diameter of 16 mm and an inside diameter of 14 mm was inserted in a Cu pipe with an outside diameter of 20 mm and an inside diameter of 16.5 mm. 200 pieces of Ag-12 at% Sn/Nb single-core composite wires produced in the same manner as in Test Example 2 were bundled, and the bundle of wires was inserted therein, to produce a 200-core composite rod. Then, the rod was subjected to groove rolling process and wire drawing, thereby obtaining a precursor wire rod which is a 200-core composite wire with an outside diameter of 0.87 mm. Fig. 3 illustrates the cross sectional structure of the precursor wire rod. The precursor wire rod was heated at temperatures ranging from 650 to 850°C for several hours to 100 hours, thereby producing an Nb₃Sn extra fine multi-core superconducting wire.

The Nb₃Sn extra fine multi-core superconducting wire thus obtained employed the single-core composite wire obtained in the embodiment of Test Example 2, and was produced in the same manner as in Test Example 2 except that materials of the pipe into which the single-core wire rod was inserted. Thus, the superconducting properties similar to those of the Nb₃Sn extra fine multi-core superconducting wire are presumably acquired. This is because, the effect as the diffusion barrier material can be acquired by the use of Ta in the bronze process, but a factor of impeding the effect as the diffusion barrier material does not particularly arise even when Ag is used in place of Cu to form Ag-Sn alloy, i.e., using Ag in place of Cu in the bronze process using Cu-Sn alloy. Therefore, it can be predicted as a natural conclusion that Ta functions as a diffusion barrier material also in the Nb₃Sn extra fine multi-core superconducting wire obtained in this embodiment. It is predicted that the critical current I_{c} becomes several hundred A when the magnetic field is 1 T or lower, and that the resistance gradually appears at the time of I_{c} measurement even when the I_{c} is high as mentioned above. More specifically, when the current is shunted into Cu compounded to the outside thereof, the superconducting state is stabilized in the same manner as in the bronze process.

In Test Example 3, Ta was used as the diffusion barrier and Cu was used as the stabilizer. However, based on the findings in the bronze process, Nb may be used as the diffusion barrier and Ag may be used as the stabilizer.

### (Test Example 4)

An Nb rod was processed into the shape of a pipe (the outside diameter of 20 mm, the inside diameter of 14 mm, and the length of 90 mm) . A composite rod which was a composite in which an Ag-12 at% Sn alloy rod was inserted was produced. The composite rod was subjected to groove rolling process, wire drawing, etc., while applying process annealing of 450°C for 1 hour under vacuum, for filamentization, thereby producing a single-core composite wire having a thickness of 0.87 mm. Subsequently, the single-core composite wire was cut to 100 mm length, and 200 wires were bundled. The bundle of wires was inserted in an Nb pipe (the outside diameter of 20 mm, the inside diameter of 14 mm, and the length of 90 mm), thereby producing a 200-core composite rod. Thereafter, the 200-core composite rod was subjected to wire drawing while applying process annealing of 400°C, thereby producing a precursor wire rod, which was a 200-core composite wire having a diameter of 0.87 mm. Fig. 4 illustrates the cross sectional structure of the precursor wire rod.

The precursor wire rod was heated at a temperature within the range of 650 to 850 ° C under vacuum for several hours to 100 hours, thereby producing an Nb₃Sn extra fine multi-core superconducting wire. The superconducting properties of the obtained Nb₃Sn extra fine multi-core superconducting wire were measured. The superconducting properties vary depending on the heat treatment conditions, and in this case the T_{c} value was 16.5 to 17.8 K, which was T_{c} value of a typical Nb₃Sn wire rod. The H_{c2} (4.2 K) value was 17 to 23 T, which was H_{c2} value of a typical additive-free Nb₃Sn wire rod. In contrast, the I_{c} (4.2K, 14T) value was 10 A to 100 A as in the case of Test Example 2.

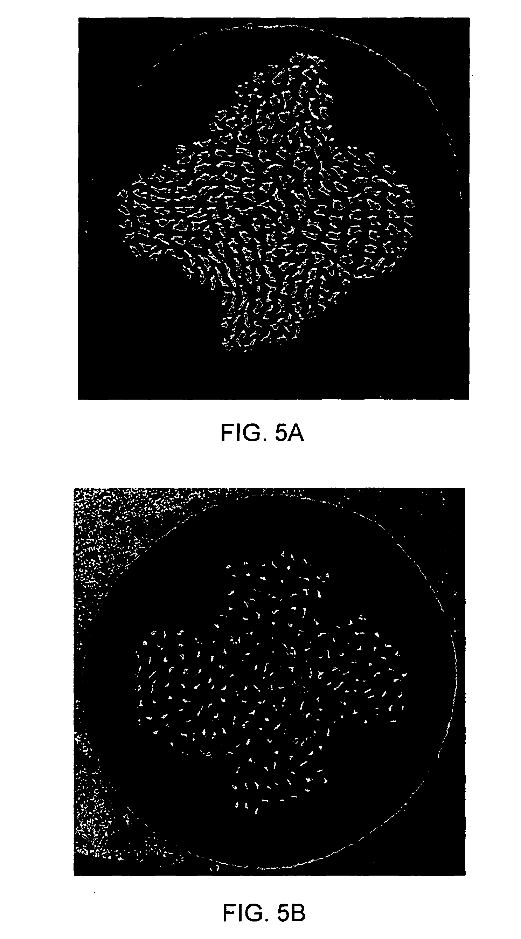

Following the above-mentioned test example under the same conditions except that the Sn concentration of Ag-Sn alloy to be inserted in an Nb pipe was 9.0 at%, thereby obtaining a 200-core Nb₃Sn superconducting wire. Figs. 5A and 5B illustrate the cross sectional views of the 200-core Nb₃Sn superconducting wire whose Sn-concentration was 9.0 at% and the 200-core Nb₃Sn superconducting wire whose Sn-concentration was 12.0 at% obtained in Test Example 4, respectively.

As shown in Figs. 5A and 5B, each of the 200-core Nb₃Sn superconducting wires has a uniform and regulated cross section, and therefore the n value is also high. Moreover, it was revealed that each of the Nb₃Sn superconducting wires of other test examples has uniform and regulated cross section, and therefore the n value is also high.

### (Test Example 5)

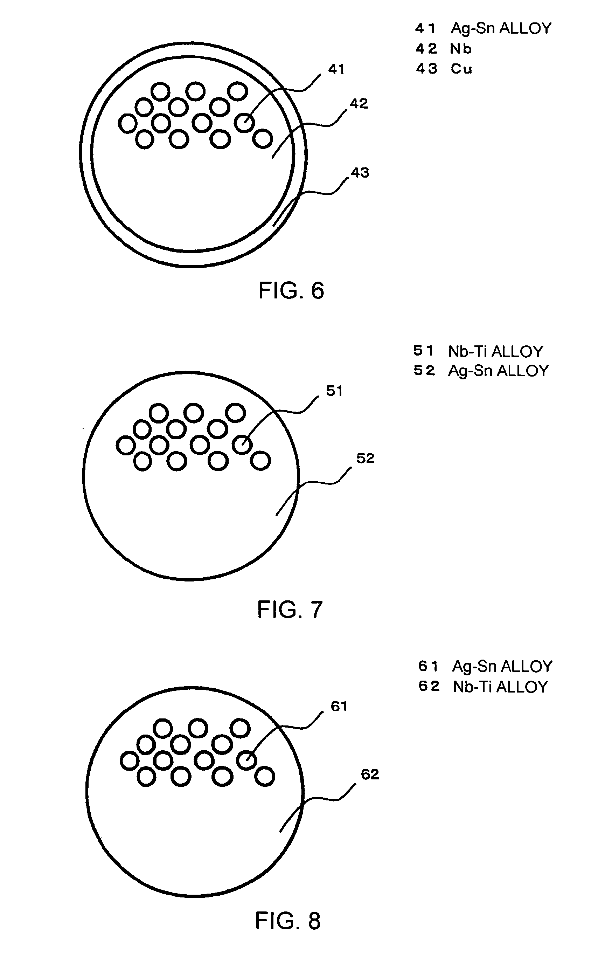

An Nb pipe whose outside diameter was 16 mm and inside diameter was 14 mm was inserted in a Cu pipe whose outside diameter was 20 mm and inside diameter was 16.2 mm, and a bundle of 200 Nb/Ag-12 at% Sn single-core composite wires, which was the wire produced in the same manner as in Test Example 4, was further inserted therein, thereby producing a composite rod. The composite rod was subjected to wire drawing, thereby producing a precursor wire rod which was a 200-core composite wire whose diameter was 0.87 mm. Fig. 6 illustrates the cross sectional structure of the precursor wire rod. The precursor wire rod was heated at a temperature within the range of 650 to 850°C under vacuum for several hours to 100 hours, thereby producing an Nb₃Sn extra fine multi-core superconducting wire.

The T_{c} value obtained after the heat treatment was 16.5 to 17.9 K, and was higher than the T_{c} value of a single-core wire rod of Comparative Example 13 described later. The I_{c} (4.2K, 14T) value reached 10 A to 100 A, which was 100 times as large as the I_{c} value of the single-core wire rod.

It was observed also in the Nb matrix wire rod that the I_{c} value sharply increased by increasing the number of cores. Due to the Cu compounded to the outside, even if the I_{c} value reached several hundred A in a low magnetic field, the resistance gradually appears when measuring the I_{c} value, which revealed that the superconducting properties of this wire rod were stabilized.

In Test Example 5, Cu was used as the stabilizer. However, Ag may be used as the stabilizer based on the findings in the bronze process.

### (Test Example 6)

In an Ag-12 at% Sn alloy pipe (the outside diameter of 20 mm, the inside diameter of 14 mm, and the length of 90 mm), an Nb-1 at% Ti alloy rod, Nb-3 at% Ti alloy rod, and an Nb-8 at% Ti alloy rod were inserted, thereby producing three kinds of single-core composite rods. The composite rods were subjected to wire drawing while applying process annealing of 400°C, thereby producing three kinds of single-core composite wires each having a diameter of 0.87 mm. Subsequently, each of the obtained single-core composite wires was cut to 100 mm length, and 200 wires were bundled. The bundle of wires was inserted in an Ag-12 at% Sn alloy pipe (the outside diameter of 20 mm, the inside diameter of 14 mm, and the length of 90 mm), thereby producing three kinds of 200-core composite rods. Thereafter, the 200-core composite rods were subjected to wire drawing while applying process annealing of 400°C, thereby producing three kinds of precursor wire rods, each of which was a 200-core composite wire having a diameter of 0.87 mm. Fig. 7 illustrates the cross sectional structure of the precursor wire rod. Subsequently, the three kinds of precursor wire rods were heated at temperatures ranging from 650 to 850°C under vacuum for several hours to 100 hours, thereby producing three kinds of Nb₃Sn extra fine multi-core superconducting wires.

In the bronze process, the H_{c2} values of Nb₃Sn and the J_{c} values in a high magnetic field are improved due to the addition of Ti. Also in the Nb₃Sn extra fine multi-core superconducting wire obtained in this test example, it can be predicted that the same improving effects can be acquired. This is because, the Ag-Sn alloy was used in place of Cu in the bronze process in this test example, but a factor of impeding the improvement effects does not arise even when Ag is used in place of Cu. It is predicted based on the findings in the bronze process that the properties were most improved by the addition of 1 at% Ti. It is also predicted that the each T_{c} value at this time is about 17.0 to 17.9 K. It is predicted that the each H_{c2} (4.2K) value is about 23 to 29 T. More specifically, when Ti was not added, the each T_{c} value was 15.2 to 17.3 K and the each H_{c2} (4.2K) value was 15 to 19 T. When compared with this case, the T_{c} and H_{c2} values are presumably clearly improved by the addition of Ti.

Similarly, it is predicted based on the findings in the bronze process to achieve the improvement that the each I_{c} value shifts to a high magnetic field side by about 2 to 4 T-in a high magnetic field. It is predicted that, when 3 at% Ti is added, the each T_{c} value is 16.3 to 17.4 K, and that the each H_{c2} (4.2K) value at this time is 17 to 23 T. More specifically, it is predicted that a slight improvement is observed by the addition of 3 at% Ti. When 8 at% Ti is added, it is predicted that the each T_{c} value is 15 K or less and the each H_{c2} (4.2 K) value is 15 T or less. More specifically, when 8 at% Ti is added, the superconducting properties are clearly to be deteriorated.

### (Test Example 7)

An Nb-1 at% Ti rod was processed into the shape of a pipe (the outside diameter of 20 mm, the inside diameter of 14 mm, and the length of 90 mm). A composite rod which was a composite in which an Ag-12 at% Sn alloy rod was inserted was produced. The composite rod was subjected to groove rolling process, wire drawing, etc., while applying process annealing of 450°C for 1 hour under vacuum, thereby producing a single-core composite wire having a thickness of 0.87 mm. Subsequently, the single-core composite wire was cut to 100 mm length, and 200 wires were bundled. The bundle of wires was inserted in an Nb-1 at% Ti alloy pipe (the outside diameter of 20 mm, the inside diameter of 14 mm, and the length of 90 mm), thereby producing a 200-core composite rod. Thereafter, the 200-core composite rod was subjected to wire drawing while applying process annealing of 400°C, thereby producing a precursor wire rod, which was a 200-core composite wire having a diameter of 0.87 mm. Fig. 8 illustrates the cross sectional structure of the precursor wire rod. The precursor wire rod was heated at a temperature within the range of 650 to 850°C under vacuum for several hours to 100 hours, thereby producing an Nb₃Sn extra fine multi-core superconducting wire.

### (Test Example 8)

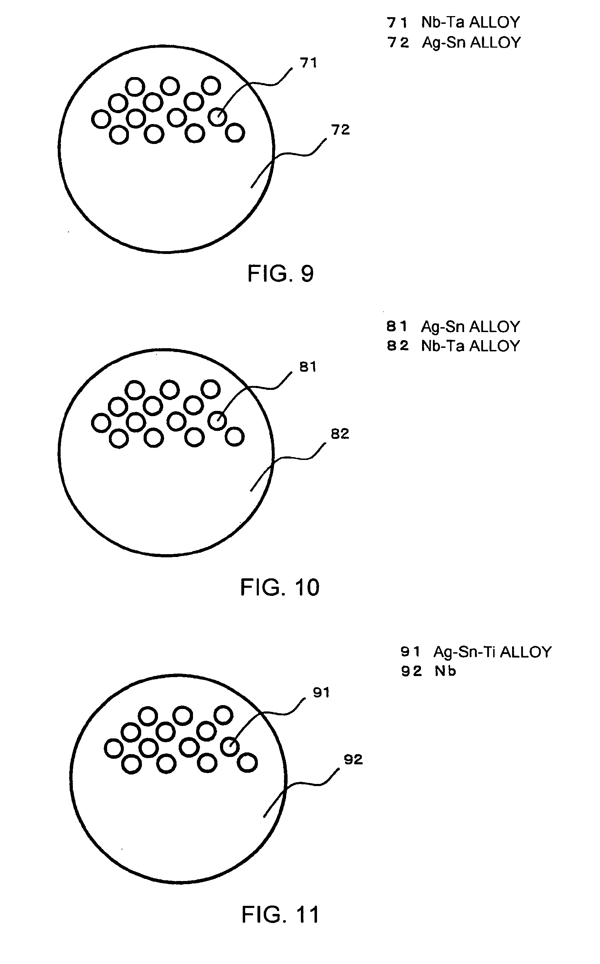

In an Ag-12 at% Sn alloy pipe (the outside diameter of 20 mm, the inside diameter of 14 mm, and the length of 90 mm), an Nb-2 at% Ta alloy rod, Nb-4 at% Ta alloy rod, and an Nb-8 at% Ta alloy rod were inserted, thereby producing three kinds of single-core composite rods. The composite rods were subjected to wire drawing while applying process annealing of 400°C, thereby producing three kinds of single-core composite wires each having a diameter of 0.87 mm. Subsequently, each of the obtained single-core composite wires was cut to 100 mm length, and 200 wires were bundled. The bundle of wires was inserted in an Ag-12 at% Sn alloy pipe (the outside diameter of 20 mm, the inside diameter of 14 mm, and the length of 90 mm), thereby producing three kinds of 200-core composite rods. Thereafter, the 200-core composite rods were subjected to wire drawing while applying process annealing of 400°C, thereby producing three kinds of precursor wire rods, each of which was a 200-core composite wire having a diameter of 0.87 mm. Fig. 9 illustrates the cross sectional structure of the precursor wire rod. Subsequently, the three kinds of precursor wire rods were heated at temperatures ranging from 650 to 850°C under vacuum for several hours to 100 hours, thereby producing three kinds of Nb₃Sn extra fine multi-core superconducting wires.

In the bronze process, the each H_{c2} value of the Nb₃Sn and the each J_{c} value in a high magnetic field are improved due to the addition of Ta. Also in the Nb₃Sn extra fine multi-core superconducting wire obtained in this test example, it can be predicted that the same improvement effects can be acquired. This is because, the Ag-Sn alloy was used in this test example in place of Cu in the bronze process, but a factor of impeding the improvement effects does not arise even when Ag is used in place of Cu. It is considered based on the findings in the bronze process that the properties are most improved by the addition of 2 at% Ti. It is also predicted that the each T_{c} value at this time is about 17.1 to 18.1 K. It is predicted that the each H_{c2} (4.2K) value is about 24 to 29 T. More specifically, when Ta was not added, the each T_{c} value was 15.2 to 17.3K and the each H_{c2} (4.2 K) value was 15 to 19 T. When compared with this case, the each T_{c} and H_{c2} values are presumably clearly improved. Similarly, it is predicted to achieve the improvement that the each I_{c} value shifts to a high magnetic field side by about 2 to 4 T in a high magnetic field. It is predicted that, when 4 at% Ta is added, the each T_{c} value is about 16.4 to 17.5 K, and that the each H_{c2} (4.2K) value at this time is about 18 to 23 T. More specifically, it is predicted that a slight improvement is observed by the addition of 3 at% Ta. When 8 at% Ta is added, it is predicted that the each T_{c} value is 16 K or less and the each H_{c2} (4.2 K) value is also 16 T or less. More specifically, when 8 at% Ta is added, the superconducting properties are presumably clearly deteriorated.

### (Test Example 9)

An Nb-2 at% Ta rod was processed into the shape of a pipe (the outside diameter of 20 mm, the inside diameter of 14 mm, and the length of 90 mm). A composite rod which was a composite in which an Ag-12 at% Sn alloy rod was inserted was produced. The composite rod was subjected to groove rolling process, wire drawing, etc., while applying process annealing of 450°C for 1 hour under vacuum, thereby producing a single-core composite wire having a thickness of 0.87 mm. Subsequently, the single-core composite wire was cut to 100 mm length, and 200 wires were bundled. The bundle of wires was inserted in an Nb-2 at% Ta alloy pipe (the outside diameter of 20 mm, the inside diameter of 14 mm, and the length of 90 mm), thereby producing a 200-core composite rod. Thereafter, the 200-core composite rod was subjected to wire drawing while applying process annealing of 400°C, thereby producing a precursor wire rod, which was a 200-core composite wire having a diameter of 0.87 mm. Fig. 10 illustrates the cross sectional structure of the precursor wire rod. The precursor wire rod was heated at a temperature within the range of 650 to 850°C under vacuum for several hours to 100 hours, thereby producing an Nb₃Sn extra fine multi-core superconducting wire.

### (Test Example 10)

An Nb rod was processed into the shape of a pipe (the outside diameter of 20 mm, the inside diameter of 14 mm, and the length of 90 mm). A composite rod which was a composite in which an Ag-12 at% Sn-1 at% Ti alloy rod was inserted was produced. The composite rod was subjected to groove rolling process, wire drawing, etc., while applying process annealing of 450°C for 1 hour under vacuum, thereby producing a single-core composite wire having a thickness of 0.87 mm. Subsequently, the single-core composite wire was cut to 100 mm length, and 200 wires were bundled. The bundle of wires was inserted in an Nb pipe (the outside diameter of 20 mm, the inside diameter of 14 mm, and the length of 90 mm), thereby producing a 200-core composite rod. Thereafter, the 200-core composite rod was subj ected to wire drawing while applying process annealing of 400 °C, thereby producing a precursor wire rod, which was a 200-core composite wire having a diameter of 0.87 mm. Fig. 11 illustrates the cross sectional structure of the precursor wire rod.

The precursor wire rod was heated at a temperature within the range of 650 to 850°C under vacuum for several hours to 100 hours, thereby producing an Nb₃Sn extra fine multi-core superconducting wire.

### (Test Example 11)

An Nb rod was processed into the shape of a pipe (the outside diameter of 20 mm, the inside diameter of 14 mm, and the length of 90 mm) . A composite rod which was a composite in which an Ag-12 at% Sn-2 at% Ta alloy rod was inserted was produced. The composite rod was subjected to groove rolling process, wire drawing, etc., while applying process annealing of 450°C for 1 hour under vacuum, thereby producing a single-core composite wire having a thickness of 0.87 mm. Subsequently, the single-core composite wire was cut to 100 mm length, and 200 wires were bundled. The bundle of wires was inserted in an Nb pipe (the outside diameter of 20 mm, the inside diameter of 14 mm, and the length of 90 mm), thereby producing a 200-core composite rod. Thereafter, the 200-core composite rod was subj ected to wire drawing while applying process annealing of 400°C, thereby producing a precursor wire rod, which was a 200-core composite wire having a diameter of 0.87 mm.

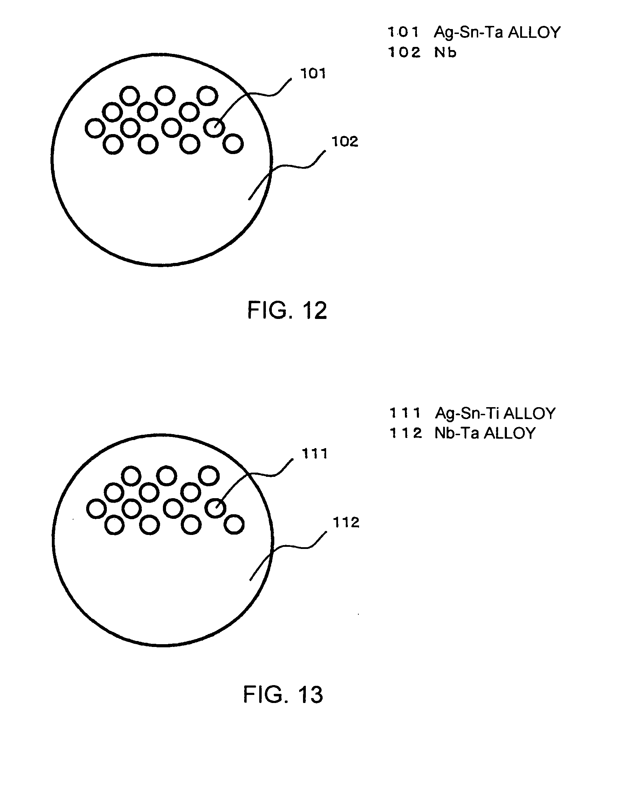

Fig. 12 illustrates the cross sectional structure of the precursor wire rod. The precursor wire rod was heated at a temperature within the range of 650 to 850°C under vacuum for several hours to 100 hours, thereby producing an Nb₃Sn extra fine multi-core superconducting wire.

### (Test Example 12)

An Nb-2 at% Ta alloy rod was processed into the shape of a pipe (the outside diameter of 20 mm, the inside diameter of 14 mm, and the length of 90 mm). A composite rod which was a composite in which an Ag-12 at% Sn-1 at% Ti alloy rod was inserted was produced. The composite rod was subjected to groove rolling process, wire drawing, etc. , while applying process annealing of 450°C for 1 hour under vacuum, thereby producing a single-core composite wire having a thickness of 0.87 mm. Subsequently, the single-core composite wire was cut to 100 mm length, and 200 wires were bundled. The bundle of wires was inserted in an Nb-2 at% Ta alloy pipe (the outside diameter of 20 mm, the inside diameter of 14 mm, and the length of 90 mm), thereby producing a 200-core composite rod. Thereafter, the 200-core composite rod was subjected to wire drawing while applying process annealing of 400°C, thereby producing a precursor wire rod, which was a 200-core composite wire having a diameter of 0.87 mm. Fig. 13 illustrates the cross sectional structure of the precursor wire rod.

The precursor wire rod was heated at a temperature within the range of 650 to 850°C under vacuum for several hours to 100 hours, thereby producing an Nb₃Sn extra fine multi-core superconducting wire.

### (Test Example 13)

4 Nb rods were processed into the shape of a pipe (the outside diameter of 20 mm and the inside diameter of 14 mm) . Composite rods in which an Ag-9 at% Sn alloy rod, Ag-12 at% Sn alloy rod, Ag-14 at% Sn alloy rod, and Ag-24 at% Sn alloy rod were each inserted were produced. The composite rods were subjected to groove rolling process, wire drawing, etc., while applying process annealing of 450°C for 1 hour under vacuum, thereby producing three kinds of single-core composite wires each having a thickness of 0.87 mm.

As illustrated in the phase diagram of Fig. 1, the Ag-9 at% Sn alloy was in the fcc phase, the Ag-12 at% Sn alloy and the Ag-14 at% Sn alloy were in the ζ phase, and the Ag-24 at% Sn was in the ε phase. With respect to the Nb/Ag-24 at% Sn composite, the core material broke along the way, and wire drawing was not completed. Thus, the Ag-Sn alloy in the ε phase was pulverized and mixed in the Nb pipe for measurement. Other composite rods were subjected to wire drawing until the target wire diameters were achieved.

Those single-core composite wires were heated at temperatures ranging from 650 to 850°C under vacuum for several hours to 100 hours, and thereafter, the superconducting properties thereof were determined. The obtained superconducting properties vary depending on the heat-treatment conditions , and the typical T_{c} value varies according to the Sn concentration of the core material. When the Ag-9 at% Sn core material was used, the T_{c} value was 14.8 to 16.5 K. When the Ag-12 at% Sn core material was used, the T_{c} value was 15.1 to 1 7.2 K. When the Ag-14 at% Sn core material was used, the T_{c} value was 15.5 to 1 7.5 K. It was revealed that when the Sn concentration in the Ag-Sn alloy was high, the T_{c} value was high.

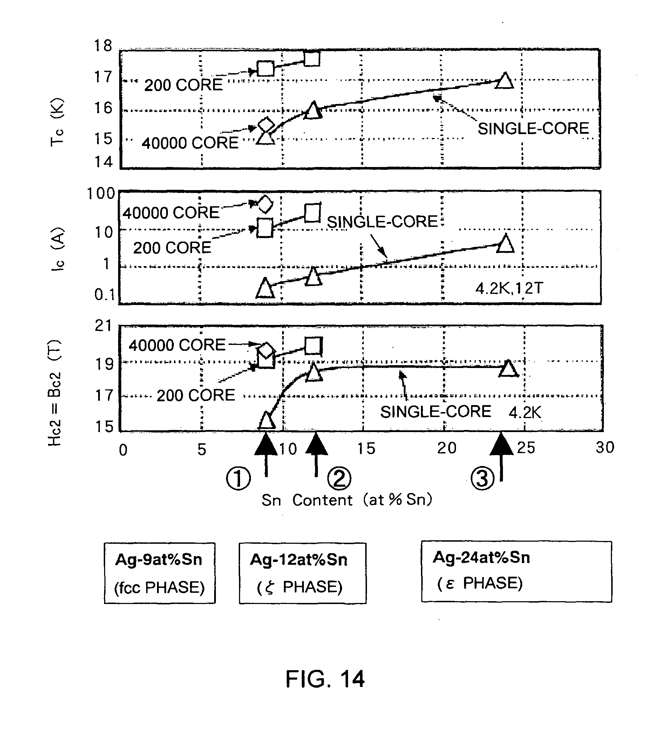

In order to examine the properties in each phase in the phase diagram of the Ag-Sn alloy, superconducting wires obtained using alloy rods each haiving the Sn concentration of 9 at% (fcc phase), 12 at% (ζ phase) , or 24 at% (E phase) used in Test Example 13 were measured for the H_{c2} (4.2 K), I_{c} (A), (4.2K, 12T), and T_{c} (K). The results are shown in Fig. 14. In Fig. 14, a triangular plot shows the measurement results of a single-core superconducting wire, a square plot shows the measurement results of a 200-core superconducting wire, and a diamond plat shows the measurement results of a 40,000-core Nb₃Sn superconducting wire. As each of the Nb₃Sn superconducting wires used in Fig. 14, the superconducting wires obtained according to the process of Test Example 1 while adjusting the Sn concentration of each wire similarly as in Test Example.

As shown in Fig. 14, in the single-core Nb₃Sn superconducting wire, the transition of the fcc phase to the ζ phase reveals that the Hc₂ value and the Tc value were notably increased. Moreover, it is revealed that the performances equivalent to or higher than those obtained by bronze process can be achieved in the ζ phase by the use of the Ag-Sn alloy irrespective of the Sn concentration, and particularly, the 200-core Nb₃Sn superconducting wire exhibited remarkably excellent performances compared with those obtained by the bronze process.

### INDUSTRIAL APPLICABILITY

According to the present invention, an Nb₃Sn superconducting wire can be provided by a new method in place of the conventional bronze process and the like, and the Nb₃Sn superconducting wire can be used for a high magnetic field generating portion of a superconducting magnet for NMR spectrometers, etc. Moreover, the present invention can provide a wire rod excellent in high magnetic field properties compared with the conventional methods such as the bronze process and the like, and therefore allows a superconducting magnet operation in a permanent current mode of 22 to 24T, which has been conventionally impossible. The super-high magnetic field NMR spectrometer plays a decisive role in determining the higher-order structure of protein, which is important in a post-genome project, and therefore the present invention can serve as a key technology. Moreover, the wire rod that can be provided by the present invention is most suitable for NMR spectrometers, and is generally suitably for the generation of high magnetic field compared with the conventional Nb₃Sn wire rod. Therefore, the wire rod of the present invention is also suitably used for high magnetic field energy storage, high magnetic field MRI, nuclear fusion reactor, high magnetic field dipole magnet, etc.

## Claims

1. A method of manufacturing an Nb₃Sn superconducting wire, comprising:
filamentizing a composite in which a core material containing an Nb material is incorporated in a matrix material containing an Ag-Sn alloy; and
heating the composite to form an Nb₃Sn filament, wherein
the composite is filamentized at a temperature at which the Ag-Sn alloy is in a state where an fcc phase and a ζ phase are mixed while adjusting an Sn concentration of the Ag-Sn alloy in such a manner that the Ag-Sn alloy can enter the state where the fcc phase and the ζ phase are mixed, or
the composite is filamentized at a temperature at which the Ag-Sn alloy is in a state in the ζ phase while adjusting an Sn concentration of the Ag-Sn alloy in such a manner that the Ag-Sn alloy can enter the state in the ζ phase.

2. A method of manufacturing an Nb₃Sn superconducting wire, comprising:
filamentizing a single-core composite in which a core material containing an Nb material is incorporated in a matrix material containing an Ag-Sn alloy;
forming a multi-core composite containing a plurality of the filamentized single-core composites;
filamentizing the multi-core composite; and
heating the multi-core composite to form an Nb₃Sn filament, wherein
the composite is filamentized at a temperature at which the Ag-Sn alloy in an fcc phase and the Ag-Sn alloy in a ζ phase are mixed while adjusting an Sn concentration of the Ag-Sn alloy in such a manner that the Ag-Sn alloy can enter the state where the Ag-Sn alloy in the fcc phase and the Ag-Sn alloy in the ζ phase are mixed, or
the composite is filamentized at a temperature at which the Ag-Sn alloy is in a state in the ζ phase while adjusting an Sn concentration of the Ag-Sn alloy in such a manner that the Ag-Sn alloy can enter the state in the ζ phase.

3. A method of manufacturing an Nb₃Sn superconducting wire according to claim 1 or 2, wherein:
the Sn concentration of the Ag-Sn alloy is 9.35 at% to 22.85 at%;
the filamentizing temperature is equal to or higher than room temperature to lower than 500°C; and
the heating temperature for generating the Nb₃Sn filament is 500°C to 724°C.

4. A method of manufacturing an Nb₃Sn superconducting wire according to claim 2, wherein:
the Sn concentration of the Ag-Sn alloy is 9.35 at% to 22.85 at%;
the filamentizing temperature is equal to or higher than room temperature to lower than 500°C;
the heating temperature for generating the Nb₃Sn filament is 500°C to 724°C; and
the multi-core composite is formed by inserting the single-core composite into an Ag-Sn alloy pipe whose Sn concentration is higher than 9.35 at% and equal to or lower than 22.85 at%.

5. A method of manufacturing an Nb₃Sn superconducting wire, comprising:
filamentizing a composite in which a core material containing an Ag-Sn alloy is incorporated in a matrix material containing an Nb material; and
heating the composite to form an Nb₃Sn filament, wherein
the composite is filamentized at a temperature at which the Ag-Sn alloy in an fcc phase and the Ag-Sn alloy in a ζ phase are mixed while adjusting an Sn concentration of the Ag-Sn alloy in such a manner that the Ag-Sn alloy can enter the state where the Ag-Sn alloy in the fcc phase and the Ag-Sn alloy in the ζ phase are mixed, or
the composite is filamentized at a temperature at which the Ag-Sn alloy is in a state in the ζ phase while adjusting the Sn concentration of the Ag-Sn alloy in such a manner that the Ag-Sn alloy can enter the state in the ζ phase.

6. A method of manufacturing an Nb₃Sn superconducting wire, comprising:
filamentizing a single-core composite in which a core material containing an Ag-Sn alloy is incorporated in a matrix material containing an Nb material;
forming a multi-core composite containing a plurality of the filamentized single-core composites;
filamentizing the multi-core composite; and
heating the multi-core composite to form an Nb₃Sn filament, wherein
the composite is filamentized at a temperature at which the Ag-Sn alloy in an fcc phase and the Ag-Sn alloy in a ζ phase are mixed while adjusting an Sn concentration of the Ag-Sn alloy in such a manner that the Ag-Sn alloy can enter the state where the Ag-Sn alloy in the fcc phase and the Ag-Sn alloy in the ζ phase are mixed, or
the composite is filamentized at a temperature at which the Ag-Sn alloy is in a state in the ζ phase while adjusting the Sn concentration of the Ag-Sn alloy in such a manner that the Ag-Sn alloy can enter the state in the ζ phase.

7. A method of manufacturing an Nb₃Sn superconducting wire according to claim 5 or 6, wherein:
the Sn concentration of the Ag-Sn alloy is 9.35 at% to 22.85 at%;
the filamentizing temperature is equal to or higher than room temperature to lower than 500°C; and
the heating temperature for generating the Nb₃Sn filament is 500°C to 900°C.

8. A method of manufacturing an Nb₃Sn superconducting wire according to claim 6, wherein:
the Sn concentration of the Ag-Sn alloy is 9.35 at% to 22.85 at%;
the filamentizing temperature is equal to or higher than room temperature to lower than 500°C;
the heating temperature for generating the Nb₃Sn filament is 500°C to 900°C; and
the multi-core composite is formed by inserting the single-core composite into the Nb material.

9. A method of manufacturing an Nb₃Sn superconducting wire according to any one of claims 1 to 8, wherein the Ag-Sn alloy incorporates therein 4 at% or lower Ti and/or 8 at% or lower Ta.

10. A method of manufacturing an Nb₃Sn superconducting wire according to any one of claims 1 to 9, wherein the Nb material incorporates therein 4 at% or lower Ti and/or 8 at% or lower Ta.

11. A method of manufacturing an Nb₃Sn superconducting wire according to any one of claims 1 to 4, comprising compounding a stabilizer containing one of Cu and Ag in the matrix material containing the Ag-Sn alloy through a diffusion barrier material containing one of Ta and Nb foil.

12. A method of manufacturing a superconducting wire according to any one of claims 5 to 8, comprising compounding a stabilizer containing one of Cu and Ag in the matrix material containing Nb.

13. An Nb₃Sn superconducting wire, comprising:
a core material containing an Nb material incorporated in a matrix material containing an Ag-Sn alloy in a ζ phase; and
Nb₃Sn formed at a boundary between the core material and the Ag-Sn alloy.

14. An Nb₃Sn superconducting wire, which is an Nb₃Sn multi-core superconducting wire, comprising:
a plurality of core materials each containing an Nb material incorporated in a matrix material containing an Ag-Sn alloy in a ζ phase; and
Nb₃Sn formed at a boundary between each of the core materials and the Ag-Sn alloy.

15. An Nb₃Sn superconducting wire, comprising:
a core material containing an Ag-Sn alloy in a ζ phase incorporated in a matrix material containing an Nb material; and
Nb₃Sn formed at a boundary between the core material and the Nb material.

16. An Nb₃Sn superconducting wire, which is an Nb₃Sn multi-core superconducting wire, comprising:
a plurality of core materials each containing an Ag-Sn alloy in a ζ phase incorporated in a matrix material containing an Nb material; and
Nb₃Sn formed at a boundary between each of the core materials and the Nb material.

17. An Nb₃Sn superconducting wire according to any one of claims 13 to 16, wherein an Sn concentration of the Ag-Sn alloy in the ζ phase is 9.35 at% to 22.85 at%.

18. A single-core composite wire, which is a single-core composite wire for manufacturing an Nb₃Sn multi-core superconducting wire, comprising a core material containing an Nb material incorporated in a matrix material containing an Ag-Sn alloy in a ζ phase.

19. A single-core composite wire, which is a single-core composite wire for manufacturing an Nb₃Sn multi-core superconducting wire, comprising a core material containing an Ag-Sn alloy in a ζ phase incorporated in a matrix material containing an Nb material.
